# EUROPÄISCHE PATENTANMELDUNG

(11) **EP 1 120 831 A2**
(43) Veröffentlichungstag der Anmeldung: **01.08.2001**
(21) Anmeldenummer: 00128185.6
(22) Anmeldetag: 21.12.2000
(51) Int. Cl.: H01L 23/552

(54) **Elektrisches Bauteil mit einer Abschirmeinrichtung**

(30) Priorität: 24.01.2000 DE 10002852
(71) Anmelder: Infineon Technologies AG, 81669 München (DE)
(72) Erfinder: Fenk, Josef, 85386 Eching (DE); Petter, Franz, 85247 Schwabhausen (DE)
(74) Vertreter: Jannig, Peter, Dipl.-Ing.

(57) **Zusammenfassung**

Die beschriebene Abschirmeinrichtung zeichnet sich dadurch aus, daß sie eine das elektromagnetisch abzuschirmende Element zumindest teilweise umgebende Beschichtung aufweist. Dadurch können die elektromagnetisch abzuschirmenden Elemente mit minimalem Aufwand optimal abgeschirmt werden.

## Beschreibung

Die vorliegende Erfindung betrifft Vorrichtungen gemäß den Oberbegriffen der Patentansprüche 1 und 11, d. h.
- eine Abschirmeinrichtung zur elektromagnetischen Abschirmung eines Halbleiter-Chips, und
- ein elektrisches Bauteil mit einem oder mehreren Halbleiter-Chips und/oder sonstigen Komponenten des das elektrische Bauteil enthaltenden Systems.

Halbleiter-Chips, genauer gesagt die darin untergebrachten integrierten Schaltungen erzeugen wie auch andere elektrische Schaltungen elektromagnetische Felder. Diese elektromagnetischen Felder können andere Komponenten des die Halbleiter-Chips enthaltenden Systems stören. Umgekehrt können Halbleiter-Chips auch durch von anderen Komponenten des die Halbleiter-Chips enthaltenden Systems erzeugten elektromagnetischen Feldern gestört werden.

Es ist daher zumindest in bestimmten Anwendungsgebieten erforderlich, Halbleiter-Chips elektromagnetisch abzuschirmen.

Dies kann beispielsweise dadurch bewerkstelligen werden, daß über den abzuschirmenden Halbleiter-Chip ein Abschirmkäfig aufgesetzt wird.

Die praktische Realisierung von Abschirmeinrichtungen dieser Art ist jedoch mit einem erheblichen Aufwand verbunden.

Entsprechende Probleme treten bei elektrischen Bauteilen auf, die einen oder mehrere Halbleiter-Chips und/oder sonstige Komponenten des das elektrische Bauteil enthaltenden Systems enthalten.

Der vorliegenden Erfindung liegt daher die Aufgabe zugrunde, die Vorrichtungen gemäß den Oberbegriffen der Patentansprüche 1 und 11 derart weiterzubilden, daß sich die elektromagnetisch abzuschirmenden Elemente mit minimalem Aufwand optimal elektromagnetisch abschirmen lassen.

Diese Aufgabe wird erfindungsgemäß durch die in den kennzeichnenden Teilen der Patentansprüche 1 und 11 beanspruchten Merkmal gelöst.

Demnach ist vorgesehen,
- daß die Abschirmeinrichtung eine den Halbleiter-Chip zumindest teilweise umgebende Beschichtung umfaßt (kennzeichnender Teil des Patentanspruchs 1) bzw.
- daß der mindestens eine Halbleiter-Chip und/oder die sonstigen Komponenten zumindest teilweise von einer elektrisch leitenden Beschichtung umgeben sind (kennzeichnender Teil des Patentanspruchs 11).

Die elektromagnetische Abschirmung von Halbleiter-Chips oder elektrischen Bauteilen, die einen oder mehrere Halbleiter-Chips und/oder sonstige Komponenten des das Bauteil enthaltenden Systems enthalten, unter Verwendung einer elektrisch leitenden Beschichtung gestaltet sich denkbar einfach. Eine solche Abschirmeinrichtung
- läßt sich problemlos mit verhältnismäßig geringem Aufwand herstellen,
- bildet mit dem elektromagnetisch abzuschirmenden Element eine zusammenhängende Einheit und kann damit - anders als beispielsweise Abschirmkäfige - keine Probleme mit der Handhabung und der Montage bereiten,
- erfordert keinen oder jedenfalls nicht in nennenswertem Umfang zusätzlichen Platz, und
- entfaltet eine optimale Abschirmwirkung.

Die Beschichtung kann zusätzlich oder alternativ dazu verwendet werden, die Seite des Halbleiter-Chips, die der Seite des Halbleiter-Chips, auf welcher die im Halbleiter-Chip untergebrachte elektrische Schaltung ausgebildet ist, gegenüberliegt, zu kontaktieren und mit einem vorbestimmten Potential (vorzugsweise Masse-Potential) zu beaufschlagen. Dadurch lassen sich gegenseitige Beeinflussungen (Verkoppelungen) zwischen verschiedenen Halbleiter-Chip-Bereichen entweder ganz vermeiden oder zumindest erheblich reduzieren, was seinerseits wiederum den positiven Effekt hat, daß der Halbleiter-Chip unempfindlicher gegen Störeinflüsse wird und sich dadurch unter allen Umständen bestimmungsgemäß betreiben läßt.

Vorteilhafte Weiterbildungen der Erfindung sind den Unteransprüchen, der nachfolgenden Beschreibung, und den Figuren entnehmbar.

Die Erfindung wird nachfolgend anhand von Ausführungsbeispielen unter Bezugnahme auf die Figuren näher erläutert. Es zeigen
- Figur 1: eine perspektivische Darstellung eines einen Halbleiter-Chip enthaltenden elektrischen Bauteils,
- Figur 2: eine Schnittansicht durch das Bauteil gemäß Figur 1 längs einer dort eingezeichneten Linie II-II,
- Figur 3: das Layout einer auf der Oberseite eines Zwischenträgers des Bauteils gemäß Figur 1 vorgesehenen oberen Leiterbahnebene,
- Figur 4: das Layout einer im Zwischenträger des Bauteils gemäß Figur 1 vorgesehenen mittleren Leiterbahnebene,
- Figur 5: das Layout einer auf der Unterseite des Zwischenträgers des Bauteils gemäß Figur 1 vorgesehenen unteren Leiterbahnebene,
- Figur 6: die Leiterbahnebene gemäß Figur 4, nachdem sie mit einer Schutzschicht (Isolierschicht) beschichtet wurde, und
- Figuren 7 bis 10: Schnittansichten von verschiedenen anderen elektrischen Bauteilen mit einem oder mehreren Halbleiter-Chips und/oder sonstigen Komponenten des das Bauteil enthaltenden Systems.

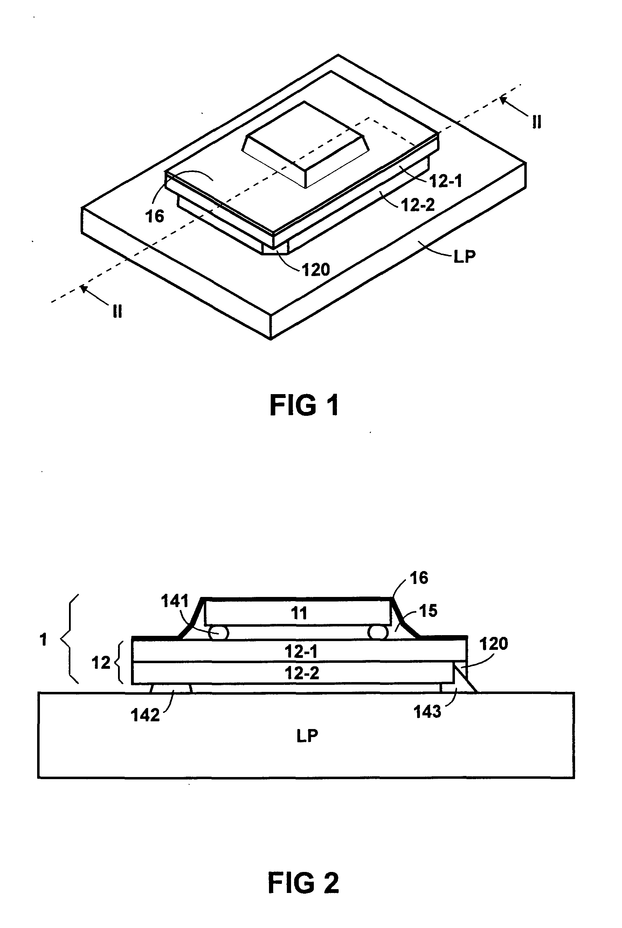

Zu den Figuren 2 und 7 bis 10 sei bereits an dieser Stelle angemerkt, daß dort, obgleich es sich um Schnittansichten handelt, die Schraffuren der besseren Übersichtlichkeit halber weggelassen wurden.

Die elektromagnetische Abschirmung von Halbleiter-Chips oder elektrischen Bauteilen, die einen oder mehrere Halbleiter-Chips oder sonstige Komponenten des das Bauteil enthaltenden Systems enthalten, wird nachfolgend anhand von mehreren verschiedenen Ausführungsbeispielen erläutert.

Den verschiedenen Ausführungsbeispielen ist gemeinsam, daß die elektromagnetische Abschirmung der elektromagnetisch abzuschirmenden Elemente unter Verwendung einer elektrisch leitenden Beschichtung erfolgt,
- welche vorzugsweise (aber nicht zwingend) direkt auf die abzuschirmenden Elemente und/oder auf eine die abzuschirmenden Elemente bedeckende und/oder umgebende (Abdeck- und/oder Füll-)Masse aufgebracht ist, und
- welche vorzugsweise (aber ebenfalls nicht zwingend) mit einem zur elektromagnetischen Abschirmung geeigneten Potential (beispielsweise Massepotential) beaufschlagt ist.

Das erste, in den Figuren 1 bis 6 gezeigte Ausführungsbeispiel betrifft die elektromagnetische Abschirmung eines Halbleiter-Chips bzw. eines einen Halbleiter-Chip enthaltenden Bauteils.

Der Halbleiter-Chip, der von der nachfolgend näher beschriebenen Abschirmeinrichtung elektromagnetisch abgeschirmt wird, ist ein beliebiger Halbleiter-Chip. Im Halbleiter-Chip ist eine beliebige analog oder digital arbeitende integrierte Schaltung untergebracht.

Der abzuschirmende Halbleiter-Chip ist im betrachteten Beispiel Bestandteil eines beispielsweise durch Verlöten, Verkleben, Zusammenstecken oder in sonstiger Weise auf eine Leiterplatte montierbaren Bauteils.

Wie später noch besser verstanden werden wird, muß der abzuschirmende Halbleiter-Chip nicht unbedingt Bestandteil eines solchen Bauteils sein. Der abzuschirmende Halbleiter-Chip kann auch dann auf die nachfolgend beschriebene Art und Weise abgeschirmt werden, wenn er direkt auf die elektrische Leiterplatte oder auf beliebige andere Vorrichtungen (beispielsweise auf einen Chipkartenkörper oder auf ein zum Einsetzen in einen Chipkartenkörper vorgesehenes Modul) montiert ist.

Der abzuschirmende Halbleiter-Chip ist in den Figuren 1 bis 6 mit dem Bezugszeichen 11 bezeichnet, und das den Halbleiter-Chip 11 enthaltende Bauteil mit dem Bezugszeichen 1. Das Bauteil 1 enthält neben dem Halbleiter-Chip 11 noch einen Zwischenträger 12.

Der Zwischenträger 12 ist eine vorzugsweise aus Keramik oder einem Leiterplattenmaterial gefertigter Verdrahtungsträger. Dieser Zwischenträger 12 trägt den Halbleiter-Chip 11 und wird zusammen mit diesem auf eine Leiterplatte LP montiert.

Die Montage des Halbleiter-Chips 11 auf die diesen tragende Vorrichtung (im betrachteten Beispiel: die Montage auf den Zwischenträger 12) erfolgt im betrachteten Beispiel nach der sogenannten Flip-Chip-Technik. Bei dieser Technik wird der Halbleiter-Chip 11 so auf dem Zwischenträger 12 montiert, daß seine die integrierte Schaltung tragende Seite dem Zwischenträger 12 zugewandt ist. Die Verbindung von Halbleiter-Chip 11 und Zwischenträger 12 erfolgt durch Verlöten oder eventuell auch durch Verkleben (unter Verwendung eines elektrisch leitenden Klebers). Die Verbindungsstellen (Lötstellen, Klebestellen) zwischen dem Halbleiter-Chip 11 und dem Zwischenträger 12 sind in den Figuren mit dem Bezugszeichen 141 bezeichnet.

Es sei bereits an dieser Stelle darauf hingewiesen, daß keine Einschränkung darauf besteht, den Halbleiter-Chip 11 unter Verwendung der Flip-Chip-Technik auf den Zwischenträger 12 zu montieren. Es wäre durchaus auch denkbar, den Halbleiter-Chip 11 unter Verwendung der sogenannten Wire-Bond-Technik, also so auf den Zwischenträger 12 zu montieren, daß seine die integrierte Schaltung tragende Oberfläche vom Zwischenträger 12 abgewandt ist.

Die Montage des Zwischenträgers 12 (und damit auch des Bauteils 1) auf die Leiterplatte LP erfolgt im betrachteten Beispiel ebenfalls durch Verlöten oder durch Verkleben (unter Verwendung eines elektrisch leitenden Klebers). Die Verbindungsstellen (Lötstellen, Klebestellen) zwischen dem Zwischenträger 12 (dem Bauteil 1) und der Leiterplatte LP sind in den Figuren mit den Bezugszeichen 142 und 143 bezeichnet.

Der Zwischenträger 12 ist im betrachteten Beispiel mehrlagig aufgebaut (Isolations- und Verdrahtungslagen). Er ist vorliegend aus einer oberen isolierenden Schicht 12-1 und einer unteren isolierenden Schicht 12-2 zusammengesetzt und weist auf seiner dem Halbleiter-Chip 11 zugewandten Oberseite, auf seiner der Leiterplatte LP zugewandten Unterseite, sowie zwischen der oberen Schicht 12-1 und der unteren Schicht 12-2 Leiterbahnebenen mit elektrisch leitenden Strukturen auf.

Die obere Schicht 12-1 und die untere Schicht 12-2 sind unterschiedlich groß; die untere Schicht 12-1 hat, wie insbesondere aus den Figuren 1, 2, 5 und 6 ersichtlich ist, gegenüber der oberen Schicht 12-1 nach innen zurückversetzte Eckbereiche 120 und wird an diesen Stellen von der oberen Schicht 12-2 seitlich überragt.

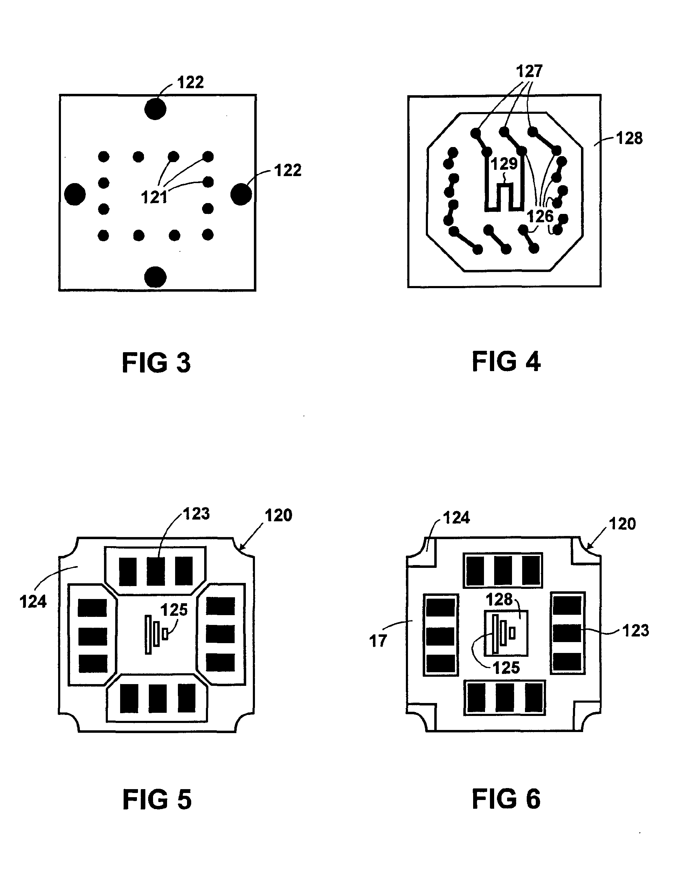

Die elektrisch leitenden Strukturen der Leiterbahnebenen des Zwischenträgers sind in den Figuren 3 (obere Leiterbahnebene auf der Zwischenträger-Oberseite), 4 (mittlere Leiterbahnebene zwischen den Zwischenträger-Schichten 12-1 und 12-2), und 5 (untere Leiterbahnebene auf der Zwischenträger-Unterseite) dargestellt.

Wie aus der Figur 3 ersichtlich ist, bestehen die elektrisch leitenden Strukturen der auf der Zwischenträger-Oberseite vorgesehenen oberen Leiterbahnebene im betrachteten Beispiel aus
- zur Verbindung mit dem Halbleiter-Chip 11 vorgesehenen Kontaktstellen 121, und
- zur Verbindung mit einer später noch genauer beschriebenen Abschirmeinrichtung zur elektromagnetischen Abschirmung des Halbleiter-Chips 11 vorgesehenen Kontaktstellen 122.

Auf die im betrachteten Beispiel zentral liegenden Kontaktstellen 121 werden die mit dem Zwischenträger 12 zu verbindenden Kontaktelemente des Halbleiter-Chips 11 gelötet oder geklebt.

Die im betrachteten Beispiel in der Randnähe liegenden Kontaktstellen 122 kommen bei der Herstellung der den Halbleiter-Chip elektromagnetisch abschirmenden Abschirmeinrichtung mit dieser in Kontakt.

Wie aus der Figur 5 ersichtlich ist, bestehen die elektrisch leitenden Strukturen der auf der Zwischenträger-Unterseite vorgesehenen unteren Leiterbahnebene im betrachteten Beispiel aus
- zur Verbindung mit der Leiterplatte LP vorgesehenen Kontaktstellen 123, und
- die Kontaktstellen 123 umgebenden Metallflächen 124.

Die Kontaktstellen 123 und Teile der Metallflächen 124 (im betrachteten Beispiel die in den Eckbereichen der Zwischenträger-Unterseite liegenden Teile der Metallfläche 124) werden mit zugeordneten Kontaktstellen der Leiterplatte LP, auf welche das Bauteil 1 zu montieren ist, verlötet oder verklebt.

Wie aus der Figur 4 ersichtlich ist, bestehen die elektrisch leitenden Strukturen der zwischen der oberen Zwischenträger-Schicht 12-1 und der unteren Zwischenträger-Schicht 12-2 liegenden mittleren Leiterbahnebene aus
- mehr oder weniger genau unter den Kontaktstellen 121 liegenden Kontaktstellen 126,
- mit den Kontaktstellen 126 verbundenen und mehr oder weniger genau über den Kontaktstellen 123 liegenden Kontaktstellen 127, und
- einer die Kontaktstellen 126 und 127 umgebenden, entlang des äußeren Randes der mittleren Leiterbahnebene verlaufenden Metallfläche 128.

Im betrachteten Beispiel ist zusätzlich zwischen ausgewählten Kontaktstellen 126 bzw. 127 eine eine Induktivität bildende spiral- oder mäanderförmige Leiterbahnstruktur 129 vorgesehen; die durch die Leiterbahnstruktur 129 gebildete Induktivität läßt sich durch Aussparungen 125 (deren Anzahl, Größe, Lage und/oder Form) im darunter liegenden Bereich der Metallfläche 124 (beispielsweise durch Lasern oder Schleifen) wunschgemäß trimmen.

Zwischen den elektrisch leitenden Strukturen der oberen Leiterbahnebene (Figur 4), der mittleren Leiterbahnebene (Figur 5), und unteren Leiterbahnebene (Figur 6) bestehen teilweise elektrische Verbindungen. Genauer gesagt
- sind die Kontaktstellen 121 der oberen Leiterbahnebene über sogenannte Durchkontaktierungen (Vias) mit den Kontaktstellen 126 der mittleren Leiterbahnebene verbunden,
- sind die Kontaktstellen 127 der mittleren Leiterbahnebene über Durchkontaktierungen mit den Kontaktstellen 123 der unteren Leiterbahnebene verbunden, und
- sind die Kontaktstellen 122 der oberen Leiterbahnebene über Durchkontaktierungen mit der Metallfläche 128 der mittleren Leiterbahnebene verbunden,
- ist die Metallfläche 128 der mittleren Leiterbahnebene über im Bereich der zurückversetzten Eckabschnitte 120 der unteren Zwischenträger-Schicht 12-2 an den seitlichen Außenflächen derselben vorgesehene Metallflächen mit der Metallfläche 124 der unteren Leiterbahnebene verbunden.

Damit sind im Ergebnis
- die zur Verbindung mit dem Halbleiter-Chip 11 vorgesehenen Kontaktstellen 121 der oberen Leiterbahnebene über die Kontaktstellen 126 und 127 der mittleren Leiterbahnebene mit den zur Verbindung mit der Leiterplatte LP vorgesehenen Kontaktstellen 123 der unteren Leiterbahnebene verbunden, und
- die zur Verbindung mit der Abschirmeinrichtung vorgesehenen Kontaktstellen 122 der oberen Leiterbahnebene mit der Metallfläche 128 der mittleren Leiterbahnebene, der Metallfläche 124 der unteren Leiterbahnebene, und der im Bereich der zurückversetzten Abschnitte 120 seitlich außen an der unteren Zwischenträger-Schicht verlaufenden Metallfläche verbunden.

Wie bereits erwähnt wurde, wird der Halbleiter-Chip 11 auf die Oberseite des Zwischenträgers 12 (auf die obere Leiterbahnebene) montiert. Die Verbindung der Kontaktelemente des Halbleiter-Chips 11 und der zugeordneten Kontaktstellen 121 der oberen Leiterbahnebene erfolgt dabei über die bereits erwähnten, durch eine Lötmasse oder einen elektrisch leitenden Kleber gebildeten Verbindungsstellen 141.

Der bei der Montage des Halbleiter-Chips 11 auf den Zwischenträger 12 zwischen dem Halbleiter-Chip 11 und dem Zwischenträger 12 verbleibende Zwischenraum wird durch eine elektrisch isolierende Füllmasse ausgefüllt. Das sogenannte Underfill 15, welches dadurch gebildet wird, erstreckt sich vorzugsweise seitlich über den Halbleiter-Chip 11 hinaus und umgibt diesen derart, daß sich von der vom Zwischenträger 12 abgewandten Seite des Halbleiter-Chips 11 eine homogene, nur allmählich (relativ flach) zum Zwischenträger 12 hin abfallende Fläche ohne scharfe Kanten und spitze Ecken ergibt. Das Underfill 15 erstreckt sich dabei jedoch höchstens bis zu den Kontaktstellen 122 der oberen Leiterbahnebene; die Kontaktstellen 122 werden durch das Underfill 15 nicht bedeckt.

Über den Halbleiter-Chip 11, die freiliegenden Bereiche des Underfill 15, und die freiliegenden Bereiche des Zwischenträgers 12 wird schließlich eine elektrisch leitende Beschichtung 16 aufgebracht. Diese elektrisch leitende Beschichtung 16 ist ein wesentliches Bestandteil der vorstehend bereits mehrfach erwähnten Abschirmeinrichtung zur elektromagnetischen Abschirmung des Halbleiter-Chips 11.

Die Beschichtung 16 wird beispielsweise durch Sputtern aufgebracht, kann aber selbstverständlich auch auf beliebige andere Art und Weise erzeugt werden.

Dadurch, daß die Beschichtung 16 nicht nur den abzuschirmenden Halbleiter-Chip 11, sondern auch die nicht vom Underfill 15 bedeckten Bereiche des Zwischenträgers 12 bedeckt, kommt sie mit den Kontaktstellen 122 der oberen Leiterbahnebene, und über diese auch mit der Metallfläche 128 der mittleren Leiterbahnebene, der Metallfläche 124 der unteren Leiterbahnebene, und den Metallflächen, die an den seitlichen Außenflächen der nach innen zurückversetzten Abschnitte 120 der unteren Zwischenträger-Schicht 12-2 vorgesehen sind, in Kontakt.

Die Metallfläche 124 der unteren Leiterbahnebene und/oder die Metallflächen, die an den seitlichen Außenflächen der nach innen zurückversetzten Abschnitte 120 der unteren Zwischenträger-Schicht 12-2 vorgesehen sind, werden bei der Montage des Zwischenträgers 12 (des Bauteils 1) auf die Leiterplatte LP elektrisch mit dieser verbunden. Dies geschieht im betrachteten Beispiel durch die vorstehend bereits erwähnten Verbindungsstellen 143. Die ebenfalls bereits erwähnten Verbindungsstellen 142 dienen zur Verbindung der Kontaktstellen 123 der unteren Leiterbahnebene mit zugeordneten Kontaktstellen der Leiterplatte LP.

Die Beschichtung 16 kann damit über die Leiterplatte LP mit Masse verbunden werden oder mit einem sonstigen zur elektromagnetischen Abschirmung geeigneten Potential beaufschlagt werden.

Die den Halbleiter-Chip 11 oben und seitlich umgebende Beschichtung 16 kann den Halbleiter-Chip damit ausgezeichnet elektromagnetisch abschirmen. Deshalb, und weil auch die mit der Beschichtung 16 verbundenen Metallflächen 128 der mittleren Leiterbahnebene und 124 der unteren Leiterbahnebene eine Abschirmungsfunktion für den Halbleiter-Chip 11 und die elektrischen Leitungen zwischen diesem und der Leiterplatte LP ausüben, ist der Halbleiter-Chip 11 auf denkbar einfache Weise optimal elektromagnetisch abgeschirmt.

Zum Schutz der unteren Leiterbahnebene kann diese, genauer gesagt die nicht mit der Leiterplatte LP zu verbindenden Stellen desselben mit einer dielektrische Eigenschaften aufweisenden Schutzschicht bzw. Isolierschicht überzogen werden. Dies ist in der Figur 6 veranschaulicht; die Schutzschicht ist dabei mit dem Bezugszeichen 17 bezeichnet.

Es dürfte einleuchten, daß ein wie beschrieben aufgebautes Bauteil 1 auch mehrere Halbleiter-Chips 11 und/oder sonstige Komponenten des das Bauteil 1 enthaltenden Systems beinhalten kann.

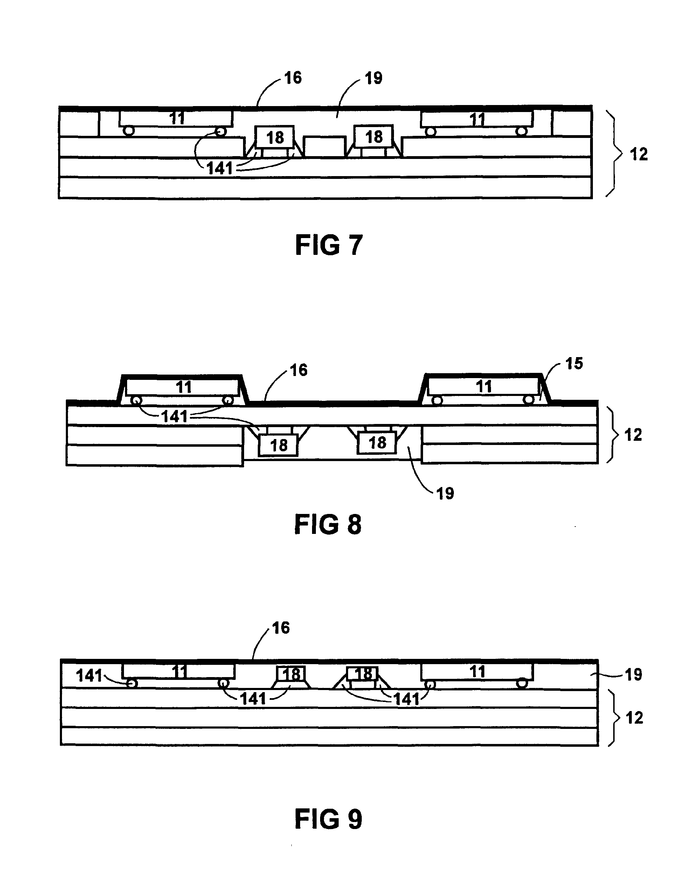

Ein Beispiel für ein solches Bauteil ist in Figur 7 dargestellt.

Das in der Figur 7 dargestellte Bauteil enthält zwei Halbleiter-Chips 11 sowie zwei weitere Bauelemente 18. Die weiteren Bauelemente 18 können Widerstände, Kondensatoren, Spulen oder beliebige andere elektrische oder elektromechanische Bauelemente sein.

Das in der Figur 7 gezeigte Bauteil unterscheidet sich von dem in den Figuren 1 bis 6 gezeigten Bauteil ferner dadurch, daß
- der Zwischenträger 12 mehr als zwei, genauer gesagt vier übereinander liegende Schichten und dementsprechend mehr Leiterbahnebenen aufweist,
- die Halbleiter-Chips 11 und die weiteren Bauelemente 18 in im Zwischenträger 12 vorgesehene Vertiefungen eingesetzt sind, und
- die Vertiefungen nach dem Einsetzen der Halbleiter-Chips 11 und der weiteren Bauelemente 18 und dem Einbringen des Underfill 15 mit einer die Halbleiter-Chips 11 seitlich umgebenden, und die weiteren Bauelemente 18 seitlich umgebenden und (zumindest bei Kurzschlußgefahr auch) bedeckenden Abdeckmasse 19 ausgegossen werden, so daß die mit der Beschichtung 16 zu versehende Fläche als eine ebene Fläche ausgebildet ist.

Eine andere Ausführungsform eines zwei Halbleiter-Chips 11 und zwei weitere Bauelemente 18 enthaltenden Bauteils ist in Figur 8 veranschaulicht.

Das in der Figur 8 gezeigte Bauteil unterscheidet sich von dem in den Figuren 1 bis 6 gezeigten Bauteil neben der Art und der Anzahl der darin vorgesehenen Bauelemente dadurch, daß
- der Zwischenträger 12 mehr als zwei, genauer gesagt drei übereinander liegende Schichten und dementsprechend mehr Leiterbahnebenen aufweist, und
- die weiteren Bauelemente 18 (und zwar nur diese) in im Zwischenträger 12 vorgesehene Vertiefungen eingesetzt sind, wobei sich die Vertiefungen auf derjenigen Seite des Zwischenträgers 12 befinden, die der die Halbleiter-Chips 11 tragenden Seite des Zwischenträgers 12 gegenüberliegt, und wobei die weiteren Bauelemente 18 nicht elektromagnetisch abgeschirmt sind.

Eine weitere Ausführungsform eines zwei Halbleiter-Chips 11 und zwei weitere Bauelemente 18 enthaltenden Bauteils ist in Figur 9 veranschaulicht.

Das in der Figur 9 gezeigte Bauteil unterscheidet sich von dem in den Figuren 1 bis 6 gezeigten Bauteil neben der Art und der Anzahl der darin vorgesehenen Bauelemente dadurch, daß
- der Zwischenträger 12 mehr als zwei, genauer gesagt drei übereinander liegende Schichten und dementsprechend mehr Leiterbahnebenen aufweist,
- sowohl die Halbleiter-Chips 11 als auch die sonstigen Komponenten 18 auf die (keine Vertiefungen aufweisende) Oberseite des Zwischenträgers 12 montiert sind,
- die Halbleiter-Chips 11 und die weiteren Bauelemente 18 nach deren Montage auf den Zwischenträger 12 und dem Einbringen des Underfill 15 mit einer die Halbleiter-Chips 11 seitlich umgebenden, und die weiteren Bauelemente 18 seitlich umgebenden und (zumindest bei Kurzschlußgefahr auch) bedeckenden Abdeckmasse 19 umgossen werden, so daß die mit der Beschichtung 16 zu versehende Fläche als eine ebene Fläche ausgebildet ist,
- die Beschichtung 16 nicht mit dem Zwischenträger 12 in Kontakt kommt, und
- die Verbindung der Beschichtung 16 mit Masse über einen (in der Figur 9 nicht gezeigten) mit Masse verbundenen Stift oder Jumper erfolgt.

Es dürfte einleuchten, daß wie beschrieben elektromagnetisch abgeschirmte Bauteile beliebige viele Halbleiter-Chips und sonstige Bauelemente enthalten können, und daß die Integration der Halbleiter-Chips und sonstigen Bauelemente in das Bauteil auch beliebig anders als bei den vorstehend erläuterten Beispielen erfolgen kann. Es muß "nur" darauf geachtet werden, daß der mit der elektromagnetisch abschirmenden Beschichtung 16 zu versehende Bereich geeignet ist, mit der Beschichtung 16 zu beschichtet werden, also insbesondere keine hohen und/oder steilen Stufen, scharfe Kanten und/oder spitze Ecken aufweist.

Eine noch effizientere Abschirmung läßt sich erzielen, wenn im Bauteil Kondensatoren integriert sind, über welche die Kontaktelemente der Halbleiter-Chips 11 oder der sonstigen Bauelemente 18 oder die damit verbundenen Leitungspfade zumindest teilweise (d.h., einzelne, mehrere oder alle Kontaktelemente oder damit verbundenen Leitungspfade) mit Masse verbunden werden. Solche Kondensatoren lassen sich dadurch realisieren, daß
- eine der Zwischenträger-Schichten aus einem eine hohe Dielektrizitätskonstante aufweisenden Material gebildet wird oder eine zusätzliche Zwischenträger-Schicht aus einem eine hohe Dielektrizitätskonstante aufweisenden Material vorgesehen wird, und
- auf der einen Seite dieser Zwischenträger-Schicht elektrisch leitende Strukturen vorgesehen werden, die mit den Kontaktelementen verbunden sind, welche über Kondensatoren mit Masse zu verbinden sind, und auf der anderen Seite dieser Zwischenträger-Schicht in Gegenüberlage zu den auf der einen Seite ausgebildeten elektrisch leitenden Strukturen mit Masse verbundene Flächen oder Strukturen vorgesehen werden.

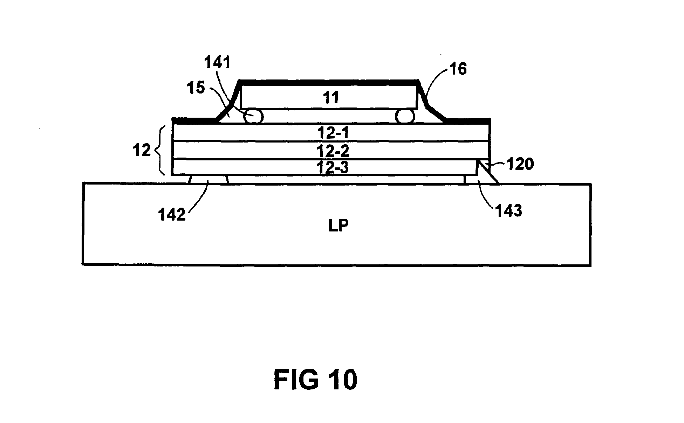

Ein derart aufgebautes Bauteil ist in Figur 10 veranschaulicht.

Das Bauteil gemäß Figur 10 entspricht weitgehend dem Bauteil gemäß den Figuren 1 bis 6. Es, genauer gesagt der Zwischenträger 12 desselben weist jedoch eine zusätzliche, aus Material mit hoher Dielektrizitätskonstante hergestellte Schicht 12-3 auf.

Die zusätzliche Zwischenträger-Schicht 12-3 weist an ihrer der Leiterplatte LP zugewandten Seite eine Leiterbahnebene auf, die wie die in den Figuren 5 und 6 gezeigte Leiterbahnebene ausgebildet und beschichtet ist. Die zwischen der zweiten Zwischenträger-Schicht 12-2 und der zusätzlichen dritten Zwischenträger-Schicht 12-3 vorgesehene Leiterbahnebene umfaßt mit den Kontaktstellen 121 bzw. 123 verbundene Strukturen, wobei diese Strukturen jedoch erheblich größere Abmessungen haben als die Kontaktstellen 121 bzw. 123, mit welchen diese verbunden sind; sie sind so groß, daß sie sich in Bereiche erstrecken, in welchen sie den mit Masse verbundenen Metallflächen 124 der untersten Leiterbahnebene gegenüberliegen. Dadurch kann die zusätzliche Zwischenträger-Schicht 12-3 zur Realisierung von Kondensatoren verwendet werden, über welche einzelne, mehrere, oder alle Kontaktelemente der im Bauteil enthaltenen Halbleiter-Chips oder sonstiger Bauelemente mit Masse verbunden werden. Dadurch kann man auf externe Abblock-Kondensatoren verzichten und die damit verbundenen Nachteile (zusätzliche diskrete Bauteile; hohe Serieninduktivität) beseitigen.

Es dürfte einleuchten, daß sich die vorstehend beschriebenen Bauteile auf mannigfaltige Art und Weise modifizieren lassen, ohne daß die Bauteile die besonderen Eigenschaften, die sie von herkömmlichen Bauteilen unterscheiden, verlieren. Insbesondere ist es nicht zwingend erforderlich, daß die Beaufschlagung der Beschichtung 16 mit einem bestimmten Potential (die Verbindung mit Masse) über die zurückversetzten Eckbereiche 120 der unteren Zwischenträger-Schicht 12-2 erfolgt. Ein Verlöten der Eckbereiche 120 mit der Leiterplatte LP hat zwar den positiven Effekt, daß das betreffende Bauteil und dessen Verbindungen mit der Leiterplatte dadurch besonders gut gegen die negativen Einflüsse geschützt sind, die aus unterschiedlichen Ausdehnungen von Bauteil und Leiterplatte bei wechselnden Temperaturen (thermal mismatch) resultieren (können). Nichtsdestotrotz kann der Zwischenträger jedoch auch ohne zurückversetzte Eckbereiche 120 ausgebildet, und/oder die Verbindung zwischen der mittleren Leiterbahnebene und der unteren Leiterbahnebene des Zwischenträgers über zusätzliche Durchkontaktierungen hergestellt werden.

Wie beschrieben oder ähnlich aufgebaute Bauteile bzw. deren Abschirmeinrichtung zur elektromagnetischen Abschirmung ermöglichen es, elektromagnetisch abzuschirmende Halbleiter-Chips und/oder sonstige Bauelemente mit minimalem Aufwand optimal elektromagnetisch abzuschirmen.

Die beschriebenen Bauteile zeichnen sich aber nicht nur durch ihre einfache und hervorragend wirkende elektromagnetische Abschirmung aus. Die Beschichtung 16 dient im betrachteten Beispiel auch dazu, die (Rück-)Seite des Halbleiter-Chips 11, die der Seite des Halbleiter-Chips, auf welcher die im Halbleiter-Chip untergebrachte elektrische Schaltung ausgebildet ist, gegenüberliegt, im betrachteten Beispiel also die vom Zwischenträger 12 abgewandte, gemäß der Darstellung in den Figuren jeweils oben liegende Seite, zu kontaktieren und mit einem vorbestimmten Potential, welches im allgemeinen vorzugsweise das Masse-Potential ist, zu beaufschlagen. Im betrachteten Beispiel erfolgt dies dadurch, daß die Beschichtung 16 großflächig mit der Rückseite des Halbleiterchips 11 verbunden ist und diese niederohmig mit den Kontaktstellen 122 des Zwischenträgers 12 verbindet. Die großflächige (vorzugsweise vollflächige) Verbindung der Halbleiter-Chip-Rückseite mit einem Bezugspotential hat den positiven Effekt, daß die Gefahr einer gegenseitigen Beeinflussung (einer Verkoppelung) von verschiedenen Halbleiter-Chip-Bereichen auf ein Minimum reduziert ist; Halbleiter-Chips, deren Rückseite großflächig und niederohmig mit einem Bezugspotential beaufschlagt ist, sind wenig anfällig gegen Störungen und sind damit auch unter schwierigen Bedingungen stets bestimmungsgemäß betreibbar.

Im betrachteten Beispiel dient die Beschichtung 16 sowohl zur elektromagnetischen Abschirmung des Halbleiter-Chips als auch zur Erdung der Halbleiter-Chip-Rückseite. Der Vollständigkeit halber sei darauf hingewiesen, daß die Beschichtung 16 auch so ausgebildet und angeordnet sein kann, daß sie "nur" zur elektromagnetischen Abschirmung oder "nur" zur Erdung der Halbleiter-Chip-Rückseite dient.

## Patentansprüche

1. Abschirmeinrichtung zur elektromagnetischen Abschirmung eines Halbleiter-Chips (11),
**dadurch gekennzeichnet,**
daß die Abschirmeinrichtung eine den Halbleiter-Chip (11) zumindest teilweise umgebende Beschichtung (16) umfaßt.

2. Abschirmeinrichtung nach Anspruch 1,
**dadurch gekennzeichnet,**
daß die Beschichtung (16) direkt auf dem Halbleiter-Chip (11) und/oder eine diesen umgebende und/oder bedeckende Masse (15, 19) aufgebracht ist.

3. Abschirmeinrichtung nach Anspruch 1 oder 2,
**dadurch gekennzeichnet,**
daß die Beschichtung (16) zumindest auch Teile der Vorrichtung (12), auf welcher der Halbleiter-Chip (11) montiert ist, bedeckt.

4. Abschirmeinrichtung nach Anspruch 3,
**dadurch gekennzeichnet,**
daß die Beschichtung (16) auf der Vorrichtung (12), auf welcher der Halbleiter-Chip (11) montiert ist, mit einer Kontaktstelle (122) in Kontakt kommt, über welche sie mit einem vorbestimmten Potential beaufschlagbar ist.

5. Abschirmeinrichtung nach Anspruch 3 oder 4,
**dadurch gekennzeichnet,**
daß der Halbleiter-Chip (11) unter Verwendung der Flip-Chip-Technik auf der ihn tragenden Vorrichtung (12) montiert ist.

6. Abschirmeinrichtung nach einem der Ansprüche 3 bis 5,
**dadurch gekennzeichnet,**
daß die Vorrichtung (12), auf welche der Halbleiter-Chip (11) montiert ist, eine elektrische Leiterplatte ist.

7. Abschirmeinrichtung nach Anspruch 6,
**dadurch gekennzeichnet,**
daß die Kontaktstellen (121, 122, 123, 126, 127) und Leiterbahnen der jeweiligen Leiterbahnebenen der elektrische Leiterplatte (12) zumindest teilweise von in den betreffenden Leiterbahnebenen vorgesehenen Metallflächen (124, 128) umgeben sind.

8. Abschirmeinrichtung nach Anspruch 7,
**dadurch gekennzeichnet,**
daß die die Kontaktstellen (121, 122, 123, 126, 127) und Leiterbahnen der Leiterbahnebenen der elektrischen Leiterplatte (12) umgebenden Metallflächen (124, 128) elektrisch mit der Beschichtung (16) verbunden sind.

9. Abschirmeinrichtung nach einem der Ansprüche 3 bis 8,
**dadurch gekennzeichnet,**
daß zwischen dem Halbleiter-Chip (11) und der diesen tragenden Vorrichtung (12) vorhandene Freiräume mit einer zum Ausfüllen von Freiräumen geeigneten Masse (15) ausgefüllt werden.

10. Abschirmeinrichtung nach einem der Ansprüche 3 bis 9,
**dadurch gekennzeichnet,**
daß der Halbleiter-Chip (11) derart mit einer zum Umgeben oder Abdecken des Halbleiter-Chips geeigneten Masse (15, 19) umgeben und/oder bedeckt ist, daß die mit der Beschichtung (16) zu versehene Fläche frei von hohen und/oder steilen Stufen, spitzen Ecken und scharfen Kanten ist.

11. Elektrisches Bauteil mit einem oder mehreren Halbleiter-Chips (11) und/oder sonstigen Komponenten (18) des das elektrische Bauteil (1) enthaltenden Systems,
**dadurch gekennzeichnet,**
daß der mindestens eine Halbleiter-Chip (11) und/oder die sonstigen Komponenten (18) zumindest teilweise von einer elektrisch leitenden Beschichtung (16) umgeben sind.

12. Elektrisches Bauteil nach Anspruch 11,
**dadurch gekennzeichnet,**
daß die Beschichtung (16) so ausgebildet und angeordnet ist, daß sie als elektromagnetischje Abschirmung für den mindestens einen Halbleiter-Chip (11) und/oder die sonstigen Komponenten (18) verwendbar ist.

13. Elektrisches Bauteil nach Anspruch 11 oder 12,
**dadurch gekennzeichnet,**
daß die Beschichtung (16) so ausgebildet und angeordnet ist, daß sie die Seite des Halbleiter-Chips, die der Seite des Halbleiter-Chips, auf welcher die auf dem Halbleiter-Chip untergebrachte Schaltung ausgebildet ist, gegenüberliegt, kontaktiert und mit einem vorbestimmten Potential beaufschlagt.

14. Elektrisches Bauteil nach Anspruch 13,
**dadurch gekennzeichnet,**
daß die Beschichtung (16) mit der Seite des Halbleiter-Chips, die der Seite des Halbleiter-Chips, auf welcher die auf dem Halbleiter-Chip untergebrachte Schaltung ausgebildet ist, gegenüberliegt, großflächig in Kontakt steht.

15. Elektrisches Bauteil nach Anspruch 13 oder 14,
**dadurch gekennzeichnet,**
daß die Beschichtung (16) die Seite des Halbleiter-Chips, die der Seite des Halbleiter-Chips, auf welcher die auf dem Halbleiter-Chip untergebrachte Schaltung ausgebildet ist, gegenüberliegt, niederohmig mit einer das vorbestimmte Potential aufweisenden Stelle verbindet.

16. Elektrisches Bauteil nach einem der Ansprüche 11 bis 15,
**dadurch gekennzeichnet,**
daß der mindestens eine Halbleiter-Chip (11) und/oder die sonstigen Komponenten (18) auf einem Zwischenträger (12) montiert sind.

17. Elektrisches Bauteil nach Anspruch 16,
**dadurch gekennzeichnet,**
daß der Zwischenträger (12) dazu ausgelegt ist, auf eine elektrischen Leiterplatte (LP) montiert zu werden.

18. Elektrisches Bauteil nach Anspruch 16 oder 17,
**dadurch gekennzeichnet,**
daß der Zwischenträger (12) durch ein mehrlagiges Substrat gebildet wird.

19. Elektrisches Bauteil nach einem der Ansprüche 11 bis 18,
**dadurch gekennzeichnet,**
daß die Beschichtung (16) direkt auf den elektromagnetisch abzuschirmende Elemente (11, 18) und/oder eine diese umgebende und/oder bedeckende Masse (15, 19) aufgebracht ist.

20. Elektrisches Bauteil nach einem der Ansprüche 16 bis 19,
**dadurch gekennzeichnet,**
daß die Beschichtung (16) zumindest auch Teile des Zwischenträgers (12) bedeckt.

21. Elektrisches Bauteil nach Anspruch 20,
**dadurch gekennzeichnet,**
daß die Beschichtung (16) auf dem Zwischenträger (12) mit einer ein vorbestimmtes Potential aufweisenden Kontaktstelle (122) in Kontakt kommt.

22. Elektrisches Bauteil nach Anspruch 21,
**dadurch gekennzeichnet,**
daß das vorbestimmte Potential Massepotential ist.

23. Elektrisches Bauteil nach einem der Ansprüche 16 bis 22,
**dadurch gekennzeichnet,**
daß der Halbleiter-Chip (11) unter Verwendung der Flip-Chip-Technik auf dem Zwischenträger (12) montiert ist.

24. Elektrisches Bauteil nach einem der Ansprüche 18 bis 23,
**dadurch gekennzeichnet,**
daß die Kontaktstellen (121, 122, 123, 126, 127) und Leiterbahnen der jeweiligen Leiterbahnebenen der den Zwischenträger (12) bildenden elektrische Leiterplatte von in den betreffenden Leiterbahnebenen vorgesehenen Metallflächen (124, 128) umgeben sind.

25. Elektrisches Bauteil nach Anspruch 24,
**dadurch gekennzeichnet,**
daß die die Kontaktstellen (121, 122, 123, 126, 127) und Leiterbahnen der Leiterbahnebenen der elektrischen Leiterplatte (12) umgebenden Metallflächen 8124, 128) elektrisch mit der Beschichtung (16) verbunden sind.

26. Elektrisches Bauteil nach Anspruch 24 oder 25,
**dadurch gekennzeichnet,**
daß im Bauteil (1) vorzusehende Spulen durch zur Spulenbildung geeignete Leiterbahn-Verläufe (129) gebildet werden.

27. Elektrisches Bauteil nach Anspruch 26,
**dadurch gekennzeichnet,**
daß oberhalb oder unterhalb der die Spulen bildenden Leiterbahnabschnitte (129) elektrisch leitende Strukturen (125) zum Trimmen der Spulen vorgesehen sind.

28. Elektrisches Bauteil nach einem der Ansprüche 16 bis 27,
**dadurch gekennzeichnet,**
daß zwischen den elektromagnetisch abzuschirmenden Elementen (11, 18) und dem Zwischenträger (12) vorhandene Freiräume mit einer zum Ausfüllen von Freiräumen geeigneten Masse (15) ausgefüllt werden.

29. Elektrisches Bauteil nach einem der Ansprüche 11 bis 28,
**dadurch gekennzeichnet,**
daß die elektromagnetisch abzuschirmenden Elemente (11) derart mit einer zum Umgeben oder Abdecken der betreffenden Elemente geeigneten Masse (15, 19) umgeben und/oder bedeckt ist, daß die mit der Beschichtung (16) zu versehene Fläche frei von hohen und/oder steilen Stufen, spitzen Ecken und scharfen Kanten ist.

30. Elektrisches Bauteil nach einem der Ansprüche 16 bis 29,
**dadurch gekennzeichnet,**
daß die auf dem Zwischenträger (12) vorgesehenen Elemente (11, 18) zumindest teilweise in im Zwischenträger vorgesehenen Vertiefungen untergebracht sind.

31. Elektrisches Bauteil nach einem der Ansprüche 16 bis 30,
**dadurch gekennzeichnet,**
daß der Zwischenträger (12) eine eine hohe Dielektrizitätskonstante aufweisende Schicht (12-3) enthält.

32. Elektrisches Bauteil nach Anspruch 31,
**dadurch gekennzeichnet,**
daß die eine hohe Dielektrizitätskonstante aufweisende Schicht (12-3) zur Realisierung von einem oder mehreren Kondensatoren verwendet wird.

33. Elektrisches Bauteil nach Anspruch 32,
**dadurch gekennzeichnet,**
daß die unter Verwendung der eine hohe Dielektrizitätskonstante aufweisende Schicht (12-3) gebildeten Kondensatoren als Abblock-Kondensatoren verwendet werden, über welche ausgewählte Kontaktelemente des mindestens einen Halbleiter-Chips (11) und/oder der sonstigen Komponenten (18) mit einem vorbestimmten Potential verbunden werden.
